# EUROPÄISCHE PATENTSCHRIFT

(11) **EP 2 694 233 B1**
(45) Veröffentlichungstag und Bekanntmachung des Hinweises auf die Patenterteilung: **08.07.2015**
(21) Anmeldenummer: 12718591.6
(22) Anmeldetag: 23.03.2012
(51) Int. Cl.: B22C 9/06, C30B 11/00, B22F 5/00, B29C 33/26, B29C 33/38, B29C 33/48, B29C 67/00, B23P 15/24

(54) **GIESSFORM ZUR HERSTELLUNG EINES GUSSKÖRPERS**
CASTING MOLD FOR PRODUCING A CAST BODY
MOULE DESTINÉ À FABRIQUER UN CORPS MOULÉ

(30) Priorität: 01.04.2011 DE 102011015799
(43) Veröffentlichungstag der Anmeldung: 12.02.2014
(73) Patentinhaber: Fraunhofer Gesellschaft zur Förderung der angewandten Forschung e.V., 80686 München (DE); Technische Universität Darmstadt, 64285 Darmstadt (DE)
(72) Erfinder: FLASCHENTRÄGER, David, 64293 Darmstadt (DE); RAUSCHENBACH, Matthias, 64289 Darmstadt (DE); MELZ, Tobias, 64285 Darmstadt (DE); ABELE, Eberhard, 77815 Brühl (DE); FISCHER, Jakob, 65527 Engenhahn (DE); STOFFREGEN, Hanns A., 60327 Frankfurt (DE)
(74) Vertreter: Rösler, Uwe
(86) Internationale Anmeldenummer: PCT/EP2012/001284
(87) Internationale Veröffentlichungsnummer: WO 2012/130417

(56) Entgegenhaltungen:
- EP-A1- 1 645 350
- WO-A1-02/34465
- WO-A1-92/11577
- GB-A- 2 119 303
- US-A- 1 418 078
- US-A- 5 562 846
- US-A1- 2010 133 725

## Beschreibung

### Technisches Gebiet

Die Erfindung bezieht sich auf eine Gießform zur Herstellung eines Gusskörpers, mit einer den herzustellenden Gusskörper konturgetreu ummantelnden Gießformwand.

### Stand der Technik

Gießtechnische Herstellungsverfahren ermöglichen eine kostengünstige Produktion von Bauteilen in großen Stückzahlen und werden zur Herstellung vielfältiger Produkte im industriellen Maßstab eingesetzt. Eine wertbestimmende Komponente von Gießverfahren betrifft die Gießform, deren Herstellung von unterschiedlichen Parametern abhängt, wie bspw. vom Gusswerkstoff, den geometrischen Eigenschaften der Gießform sowie der Stückzahl der zu gießenden Gusskörper, die letztlich den materiellen, zeitlichen aber insbesondere finanziellen Aufwand bestimmen. Bei den Gießformen wird grundsätzlich zwischen sog. Dauerformen und verlorenen Formen unterschieden. Dauerformen, die für eine Vielfachverwendung geeignet sind, erfordern für deren Herstellung zumeist einen immensen Kosten- und Zeitaufwand, zumal sie robust genug ausgebildet sein müssen, um den hohen Qualitätsanforderungen bzgl. einer Vielfachreproduktion von Gusskörpern unter Maßgabe einer hohen Maßhaltigkeit zu entsprechen. Darüber hinaus bestehen für die Auslegung von Dauergießformen Fertigungs- und Entformbarkeitsrestriktionen, wie z. B. die Vermeidung von Hinterschneidungen, um eine für den Gusskörper schadlose Separation von der Gießform nach entsprechendem Erkalten des Gusskörpers zu ermöglichen.

Verlorene Gießformen werden hingegen nach jedem einzelnen Gießprozess zerstört um auf diese Weise Zugang zu dem Gusskörper zu erhalten. Zwar sind die Anforderungen in Bezug auf Robustheit an eine verlorene Gießform weit geringer als im Vergleich zu Dauergießformen, gleichwohl gilt es auch bei der Herstellung verlorener Gießformen ein Modell des Gießkörpers anzufertigen. Insofern sind auch in diesem Falle je nach Größe und räumlicher Beschaffenheit des Gusskörpers zeit-und kostenintensive Vorarbeiten zu leisten.

Gießtechnische Herstellungsverfahren würden sich jedoch neben der Herstellung von Massenprodukten durchaus auch zur Herstellung technischer/elektronischer Produkte eignen, deren Anwendung in der Großserie noch nicht etabliert ist. Als Beispiel hierfür ist die Herstellung von adaptronischen Komponenten zu nennen, die zumeist aus Wandlermaterial bestehende Aktoren und/oder Sensoren umfassen, die in einer die technischen Elemente schützenden Umhüllung vergossen sind. Derartige adaptronische Komponenten werden bislang in mittels Aluminiumdruckgussverfahren hergestellte Hausungen integriert oder mittels Epoxidharz oder Siliconkautschuk vergossen.

Aus US 1 418 078 A ist eine aufklappbare Gießform bekannt, die aus einer Basis und vier daran schwenkbar angeordneten Gießformsegmenten besteht Die US 2010/133725 A1 zeigt eine Gießform aus Polymermaterial zur gleichzeitigen Herstellung mehrerer künstlicher Steine, bei der der Zwischenbereich zwischen den jeweiligen Gießformen mit einem Nylon-Gitter verstärkt ist. In GB 2 119 303 A wird eine Gießform zur Herstellung eines Kunststoff-Komposit-Produkts offenbart, die über zwei zueinander schwenkbare Gießformwandsegmente verfügt, welche über eine flexiblen Bereich miteinander verbunden sind. Die WO 02/34465 A1 zeigt ein Verfahren zur Herstellung eines dreidimensionalen Körpers mithilfe eines spanenden Fertigungsverfahrens. Aus US 5 562 846 A ist die generative Fertigung einer Gießform mit Kühlkanälen bekannt. In WO 92/11577 A1 ist ein generatives Verfahren zur Herstellung eines 3D-Objekts offenbart, bei dem zur Verbesserung der Maßhaltigkeit die Objektoberfläche während der Herstellung vermessen wird. Aus EP 1 645 350 A1 ist das Vergießen eines Funktionselements in der Kavität einer Gussform bekannt.

### Darstellung der Erfindung

Der Erfindung liegt die Aufgabe zugrunde eine Gießform zur Herstellung eines Gusskörpers, mit einer den herzustellenden Gusskörper konturgetreu ummantelnden Gießformwand, möglichst kostensparend herzustellen, um die wirtschaftliche Voraussetzung zu schaffen, Gusskörper auch in Kleinserien in finanziell akzeptablen Rahmen herzustellen. Insbesondere soll es möglich sein, eine Gießform bereitzustellen, die den bei Dauerformen bestehenden Fertigungs- und Entformbarkeitsrestriktionen nicht unterliegen. Selbst die Erzeugung komplizierter Freiformflächen an der den Gusskörperkontur getreu ummantelnden Gießformwand soll ohne erhebliche Zusatzkosten möglich werden. In besonderer Weise soll die Gießform für Entwicklungsarbeiten sowie für die Kleinserienfertigung von Gusskörpern, insbesondere Gusskörpern mit adaptronischen Komponenten, geeignet sein. Die Herstellung wunschgemäßer Gießformen soll schnell, flexibel, leicht modifizierbar und letztlich preiswert möglich sein.

Die Lösung der der Erfindung zugrunde liegenden Aufgabe ist im Anspruch 1 angegeben. Den Erfindungsgedanken in vorteilhafter Weise weiterbildende Merkmale sind Gegenstand der Unteransprüche sowie der weiteren Beschreibung unter Bezugnahme auf die Ausführungsbeispiele zu entnehmen.

Lösungsgemäß zeichnet sich eine Gießform zur Herstellung eines Gusskörpers, mit einer den herzustellenden Gusskörper konturgetreu ummantelnden Gießformwand dadurch aus, dass die Gießformwand in wenigstens zwei Gießformwandsegmente unterteilbar ist, die über einen Gelenkbereich einstückig und fluiddicht miteinander verbunden sind. Hierbei ist der Gelenkbereich derart ausgebildet und angeordnet, dass die wenigstens zwei Gießformwandsegmente relativ zueinander schwenkbar um eine den Gelenkbereich zuordenbare Schwenkachse gelagert sind. Sowohl die wenigstens zwei Gießformwandsegmente als auch der Gelenkbereich sind lösungsgemäß mittels eines generativen Herstellungsverfahrens hergestellt.

Generative Herstellungsverfahren, die auch als Rapid-Prototyping-Fertigungsverfahren bezeichnet werden, ermöglichen eine schichtweise Fertigung eines Körpers, dessen Form- und Größedaten als CAD-Datensatz vorliegend, die dem generativen Fertigungsverfahren in Form von Fertigungsparametern zugeführt werden. Für die Herstellung der lösungsgemäßen Gießform eignet sich wenigstens eines der nachfolgenden generativen Fertigungsverfahren: Rapid-Prototyping mittels photolithographischen Verfahren, Photopolymerisation durch schichtweises Aushärten aus einem Flüssigkeitsbad, schichtweises Auftragen und Verfestigen von Pulverschichten, schichtweises Austragen eines Bindemittels in einen Pulververbund, Energiestrahldepositionsverfahren in Metallpulver, Kunststoffextrudertechnik, wie bspw. Fused-Deposition-Modelling, kurz FDM.

Mit Hilfe der vorstehend genannten generativen Verfahrenstechniken ist es möglich, eine Gießform mit individuell vorgebbarer Raumform ohne die vorherige Notwendigkeit der Anfertigung eines Gießkörpermodells herzustellen.

Um darüber hinaus die bei Dauerformen bestehende Entformbarkeitsrestriktion zu umgehen oder zumindest deutlich zu entschärfen, besteht die lösungsgemäße Gießform aus zwei über einen Gelenkbereich einstückig miteinander verbundenen Gießformwandsegmenten, die längs des Gelenkbereiches schwenkbar gelagert sind. Auf diese Weise können die wenigstens zwei Gießformwandsegmente aus einer ersten, zusammengefügten Position, in der der Gießprozess durchgeführt wird, in eine zweite, aufgeklappte Position überführt werden, nachdem der Gusskörper erkaltet bzw. verfestigt ist und durch Separation aus der Gießform entnommen werden kann.

Der wenigstens eine, die beiden Gießformwandsegmente miteinander verbindende Gelenkbereich wird vorzugsweise als Filmgelenk ausgebildet, d. h. innerhalb des Gelenkbereiches ist ein geradliniger Verbindungsbereich mit einer gegenüber der übrigen Gießformwandsegmentstärke stark reduzierten Wandstärke ausgebildet. Längs des geradlinig und wanddickenreduzierten Gelenkbereich sind beide Gießformwandsegmente aufgrund der Eigenelastizität des Gießformwandmaterials schwenkbar.

Der jeweils als Filmgelenk ausgebildete Gelenkbereich gewährleistet eine nahtlose Verbindung zwischen beiden Gießformwandsegmenten, so dass sie in Bezug auf das in die Gießform zu verfüllende Gussmaterial auch im Gelenkbereich fluiddicht abdichten. Der Begriff "fluiddicht" ist insbesondere als flüssigkeitssdicht zu verstehen.

Neben gängigen generativen Herstellungsverfahren, in denen der generativ herzustellende Körper aus einem einheitlichen Material gefertigt wird, sind auch weiterentwickelte generative Herstellungsverfahren bekannt, in denen zwei oder mehrere Materialien mit unterschiedlichen Materialeigenschaften zur Herstellung eines einstückig gefertigten Körpers eingesetzt werden. In besonders vorteilhafter Weise weist eine lösungsgemäß ausgebildete Gießform unter Verwendung eines derart weiterentwickelten Herstellungsverfahrens zumindest im Gelenkbereich ein anderes Material auf, als jenes, aus dem die Gießformwandsegmente gefertigt sind. Vorzugsweise ist die Materialwahl für den Gelenkbereich derart getroffen, dass das Material über eine erhöhte Elastizität verfügt.

Durch die einstückige Fertigungsmethode mit Hilfe generativer Herstellungsverfahren kann auf Maßnahmen zur Fixierung, Arretierung sowie auch Ausrichtung getrennt ausgebildeter Gießformteile, wie dies beim Stand der Technik häufig üblich ist, verzichtet werden. Zudem ist durch den lösungsgemäßen Einsatz generativer Herstellungsverfahren für die Ausbildung einer Gießform der zeitliche Aufwand zur Herstellung der Gießform nahezu unabhängig vom Komplexitätsgrad des mit der Gießform herzustellenden Gusskörpers. Mit Hilfe des generativen Herstellungsverfahrens ist es überdies möglich, eine Gießform für komplexe Gusskörpergeometrien in kurzer Zeit zu fertigen, wobei auch Weiterentwicklungen oder Modifikationen an der Gießform durch entsprechende Korrekturen oder Abänderungen am die Gießform beschreibenden CAD-Datensatz möglich sind. Die lösungsgemäß ausgebildete Gießform eignet sich damit in besonderer Weise für Entwicklungsarbeiten sowie die Kleinserienfertigung. Ungeachtet dessen lässt sich eine mittels generativen Herstellungsverfahren gewonnene Gießform auch für die Serienfertigung von Bauteilen und Komponenten einsetzen.

Der lösungsgemäße Gedanke soll anhand einer konkreten Ausführungsform näher erläutert werden.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1a bis e: schematisierte Sequenzbilddarstellungen zur Erläuterung des gießtechnischen Einsatzes einer lösungsgemäß ausgefertigten Gießform,
- Fig. 2: Gießform mit integrierten Kühlkanälen,
- Fig. 3: Gießform mit zusätzlicher Stützstruktur.

### Wege zur Ausführung der Erfindung, gewerbliche Verwendbarkeit

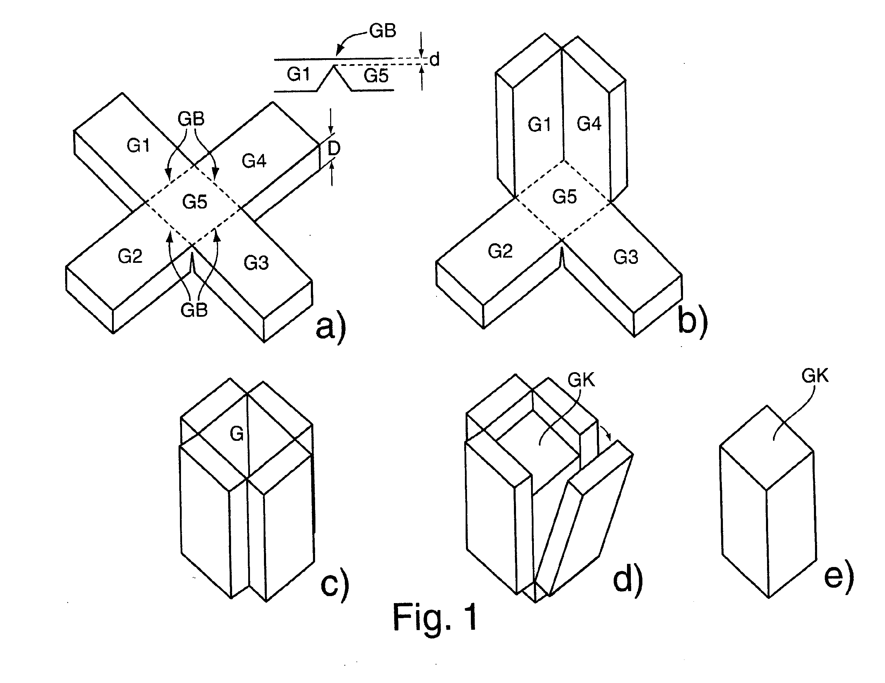

Figur 1a zeigt eine perspektivische Draufsicht auf eine mittels generativem Herstellungsverfahren hergestellte Gießform, die aus fünf einstückig miteinander verbundenen Gießformwandsegmenten G1, G2, G3, G4, G5 besteht. Die Gießformwandsegmente G1 bis G5 sind flächig ausgebildet und weisen allesamt eine einheitliche Wandstärke D auf. Das Gießformwandsegment G5 besitzt im dargestellten Ausführungsbeispiel eine quadratische Flächenform. Die Gießformwandsegmente G1 bis G4 weisen hingegen eine einheitliche rechteckförmige Flächenform auf und sind im Übrigen quaderförmig ausgebildet. Die quaderförmig ausgebildeten Gießformwandsegmente G1 bis G4 sind mit jeweils einer ihrer Seitenkante einstückig mit dem Gießformwandsegment G5 unter Ausbildung eines Gelenkbereiches verbunden. Zur näheren Illustration des Gelenkbereiches GB zwischen den jeweils aneinander grenzenden Gussteilsegmenten G1 bis G4 mit G5 sei auf die oberhalb von Figur 1 a illustrierte Querschnittsteildarstellung verwiesen. Die Querschnittsteildarstellung zeigt den Gelenkbereich GB zwischen den Gießformwandsegmenten G1 und G5. Der Gelenkbereich GB weist eine stark reduzierte Gießformwandstärke d auf und verfügt durch die Wandstärkenreduzierung über eine lokale Elastizität, die es ermöglicht, dass die Gießformwandsegmente G1 bis G4 um 90° nach oben schwenkbar sind. In Figur 1b sind die Gießformwandsegmente G1 und G2 um 90° nach oben geschwenkt, so dass sie längs ihrer beiden Seitenkanten unmittelbar aneinander grenzen. In einer bevorzugten Ausführungsform sind die jeweils aneinander in Kontakt bringbaren Seitenkanten der Gießformwandsegmente G1 bis G4 geeignet strukturiert ausgeführt, so dass sie in Bezug auf ein in die Gießform einbringbares Gussmaterial dichtend miteinander abschließen. Vorzugsweise können die Seitenkanten hierzu ein Gehrungsprofil aufweisen, über die die Seitenkanten flächig aneinander grenzen.

In Figur 1c sind sämtliche Gießformwandsegmente G1 bis G4 relativ zum Gießformwandsegment G5 nach oben geklappt und schließen ein einseitig offenes Gussvolumen G ein. Im darauf folgenden Gießprozess wird in die Gießform flüssiges Gussmaterial eingefüllt, das nach Erkalten und/oder Erstarren und/oder Aushärten von der Gießform zu separieren ist. Zum Zwecke des Separierens werden die Gießformwandsegmente G1 bis G4 nacheinander vom Gusskörper um ihre jeweiligen Gelenkbereich, mit denen sie mit dem Gießformwandsegment G5 verbunden sind, zurück geklappt (siehe hierzu Figur 1d). Letztlich gilt es den fertig gestellten Gusskörper GK aus der allseitig geöffneten Gießform zu trennen (Fig. 1e).

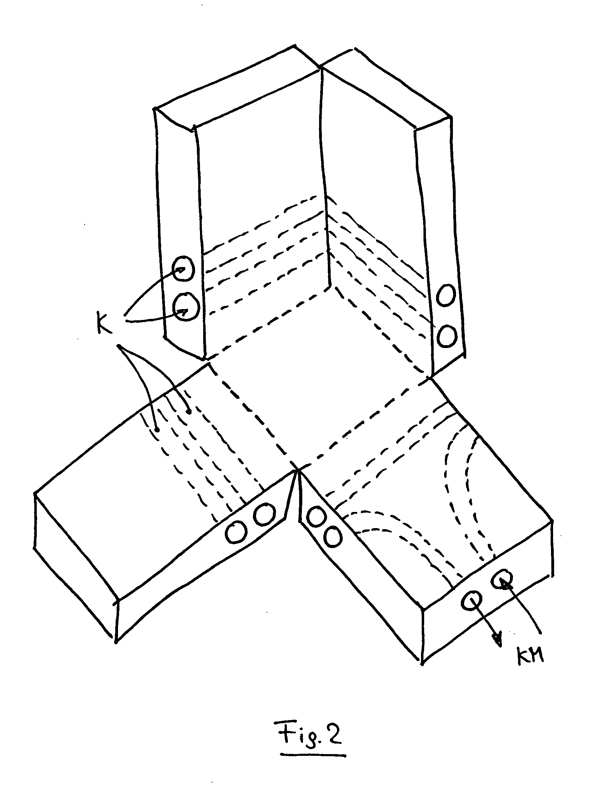

In Figur 2 ist eine weitere Ausführungsform einer lösungsgemäß ausgebildeten Gießform illustriert, die über innere Kühlkanäle K verfügt. Im Rahmen des generativen Herstellungsverfahrens können die für die Kühlkanäle K erforderlichen Hohlräume innerhalb der Gießformwandsegmente G1 bis G5 entsprechend vorgesehen werden. Durch Aneinanderfügen der Gießformwandsegmente G1 bis G5 in der vorstehend erläuterten Weise bilden sie ein fluiddichtes Kühlleitungssystem, durch das ein Kühlmedium KM, bspw. Kühlflüssigkeit hindurchgeführt werden kann.

Eine derartige Kühlmaßnahme ist vorteilhaft für ein beschleunigtes Abkühlen des fließfähigen und somit heißen Gussmaterials unmittelbar nach Verfüllen der Gießform.

Selbstverständlich ist es möglich, derartige Kühlkanalstrukturen auch nachträglich mit Hilfe mechanischer Nachbearbeitungsmethoden, bspw. Bohren, Fräsen oder Erodieren in die jeweiligen Gießformwandsegmente einzubringen.

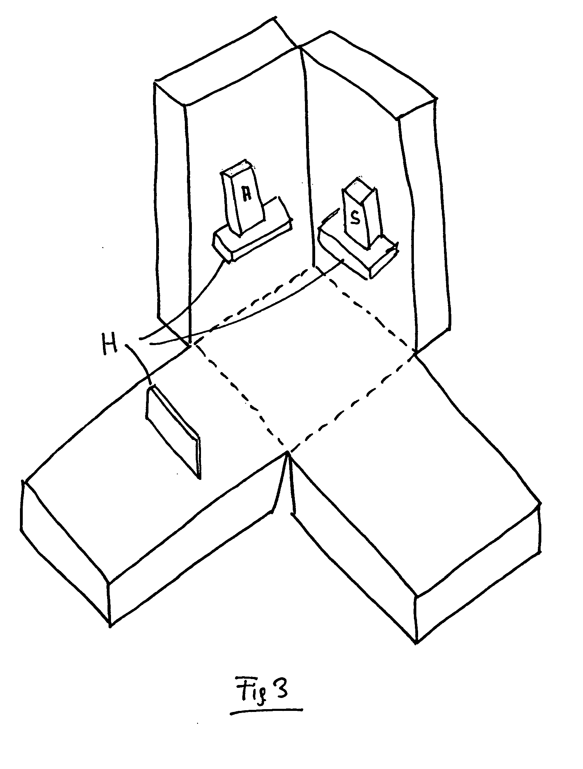

Für die gießtechnische Herstellung von adaptronischen Bauelementen, in denen Aktoren und/oder Sensoren aus Wandiermaterialien integriert sind, ist es vorteilhaft, wenn nicht sogar erforderlich, entsprechende Haltestrukturen H für die Anbringung entsprechender Aktoren A oder Sensoren S innerhalb des Gießvolumens an den Gießformwandsegmenten vorzusehen, siehe Figur 3. Vor der gießtechnischen Verfüllung der Gießform werden entsprechende Aktoren A bzw. Sensoren S auf die Haltestrukturen H aufgebracht.

Neben den erwähnten Kühlkanälen K sowie Haltestrukturen H, die einstückig innerhalb der Gießformwandsegmente im Rahmen des generativen Herstellungsverfahrens eingebracht werden können, können auch weitere Stütz- und Funktionsflächen bzw. Strukturen zur Versteifung der Gießform sowie auch Formgebung des Gusskörpers an der Gießform vorgesehen werden.

Neben der bereits erwähnten Maßnahme die Seitenkanten der Gießformwandsegmente geeignet zu strukturieren, um ein Entweichen des flüssigen Gussmaterials zwischen den aneinander gefügten Gießformwandsegmenten zu vermeiden, können vor dem Zusammenklappen bzw. Zusammenfügen der einzelnen Gießformwandsegmente die Seitenkanten mit entsprechenden Dichtmassen, wie bspw. Wachs, Klebstoff, Silikon oder ähnliche Mittel belegt werden.

### Bezugszeichenliste

- G1 bis G5: Gießformwandsegmente
- G: Gussvolumen
- GK: Gusskörper
- A: Aktor
- S: Sensor
- H: Haltestruktur
- K: Kühlkanal
- KM: Kühlmittel

## Patentansprüche

1. Gießform zur Herstellung eines Gusskörpers (GK), mit einer den herzustellenden Gusskörper (GK) konturgetreu ummantelnden Gießformwand, **dadurch gekennzeichnet, dass** die Gießformwand in wenigstens zwei Gießformwandsegmente (G1-G5) unterteilbar ist, die über einen Gelenkbereich einstückig und fluiddicht miteinander verbunden sind,
dass der Gelenkbereich derart ausgebildet und angeordnet ist, dass die wenigstens zwei Gießformwandsegmente (G1-G5) relativ zueinander schwenkbar um eine dem Gelenkbereich zuordenbare Schwenkachse gelagert sind,
und dass die wenigstens zwei Gießformwandsegmente (G1-G5) und der Gelenkbereich mittels eines generativen Herstellungsverfahrens hergestellt sind.

2. Gießform nach Anspruch 1,
**dadurch gekennzeichnet, dass** der Gelenkbereich als Filmgelenk ausgebildet ist.

3. Gießform nach Anspruch 1 oder 2,
**dadurch gekennzeichnet, dass** die zu fertigende Gießform nach Form und Größe als CAD-Datensatz vorliegt, der einem generativen Fertigungsverfahren in einer der folgenden Art als Fertigungsparameter zuführbar ist:
- Rapid Prototyping mittels Photolithographischem Verfahren
- Photopolymerisation durch schichtweises Aushärten aus einem Flüssigkeitsbad
- Schichtweises Auftragen und Verfestigen von Pulverschichten
- Schichtweises Austragen eines Bindemittels in einen Pulververbund
- Energiestrahldepositionsverfahren in Metallpulver
- Kunststoffextrudertechnik, wie z.B. Fused Deposition Modeling

4. Gießform nach einem der Ansprüche 1 bis 3,
**dadurch gekennzeichnet, dass** die wenigstens zwei Gießformwandsegmente (G1-G5) sowie der Gelenkbereich einstückig aus einem einheitlichen Material gefertigt sind.

5. Gießform nach einem der Ansprüche 1 bis 3,
**dadurch gekennzeichnet, dass** der Gelenkbereich aus einem anderen Material gefertigt ist als die Gießformwandsegmente (G1-G5).

6. Gießform nach einem der Ansprüche 1 bis 5,
**dadurch gekennzeichnet, dass** die Gießformwandsegmente (G1-G5) als Flächenelemente ausgebildet sind, die im Rahmen des Herstellungsverfahrens eine gemeinsame Ebene aufspannen, aus der zumindest drei über die jeweiligen Gelenkbereiche mit wenigstens einem weiteren Flächenelement verbundenen Flächenelemente unter Ausbildung der Gießform schwenkbar sind.

7. Gießform nach einem der Ansprüche 1 bis 6,
**dadurch gekennzeichnet, dass** die wenigstens zwei Flächenelemente Fügekanten aufweisen, längs der die wenigstens zwei Flächenelemente durch Schwenken um den Gelenkbereich in gegenseitige Anlage bringbar sind,
und dass die Fügekanten derart geformt und/oder mit einem Dichtmittel versehen sind, dass die Flächenelemente dichtend in Bezug auf das fließfähige Gussmaterial während des Gießvorganges miteinander abschliessen.

8. Gießform nach Anspruch 7,
**dadurch gekennzeichnet, dass** die Fügekanten in Art eines Gehrungsprofils ausgebildet sind.

9. Gießform nach einem der Ansprüche 1 bis 8,
**dadurch gekennzeichnet, dass** wenigstens eine Gießformwand eine dem herzustellenden Gusskörper (GK) zugewandte Innenwandfläche mit wenigstens einer einstückig mit dieser verbundenen Gießformstruktur aufweist.

10. Gießform nach Anspruch 9,
**dadurch gekennzeichnet, dass** die wenigstens eine Gießformstruktur als Halte- oder Befestigungsstruktur für einen innerhalb des Gusskörpers (GK) zu positionierenden Körper ausgebildet ist.

11. Gießform nach Anspruch 10,
**dadurch gekennzeichnet, dass** der zu positionierende Körper ein Wandlermaterial aufweisender Aktor (A) oder Sensor (S) ist.

12. Gießform nach einem der Ansprüche 1 bis 11,
**dadurch gekennzeichnet, dass** innerhalb wenigstens eines Gießformwandsegmentes (G1-G5) ein Hohlraum in Art eines Kanals, einer Röhre oder einer Kapillare, durch die ein Kühlmedium (KM) leitbar ist, vorgesehen ist.

13. Gießform nach einem der Ansprüche 1 bis 12,
**dadurch gekennzeichnet, dass** wenigstens ein Gießformwandsegment (G1-G5) wenigstens einen ersten Wandbereich aufweist, der eine gegenüber dem übrigen Wandbereich des Gießformwandsegmentes (G1-G5) reduzierte Wandstärke aufweist, und dass der erste Wandbereich mit dem übrigen Wandbereich des Gießformwandsegmentes (G1-G5) über einen Sollbruchbereich einstückig verbunden ist, der beim Separieren des Gusskörpers (GK) von der Gießform aufbricht und der erste Wandbereich mit dem Gusskörper (GK) verbunden bleibt.

## Claims

1. Casting mould for producing a cast body (GK) with a casting mould wall surrounding and conforming to the contour of the cast body (GK) to be produced,
**characterized in that** the casting mould wall is divisible into at least two mould wall segments (G1-G5), which are connected to each other integrally and in fluid-tight manner via a hinge region,
that the hinge region is constructed and arranged such that the at least two mould wall segments (G1-G5) are pivotable relative to one another about a swivel axis that can be assigned to the hinge region,
and that the at least two mould wall segments (G1-G5) and the hinge region are produced by means of a generative manufacturing method.

2. Casting mould according to claim 1, **characterized in that** the hinge region is designed as a film hinge.

3. Casting mould according to either of claims 1 or 2, **characterized in that** the data regarding size and shape of the casting mould to be produced is present in the form of a CAD dataset, which can be introduced into a generative manufacturing process as manufacturing parameters in one of the following ways:
- Rapid prototyping using a photolithographic method
- Photopolymerisation by layer-wise curing from a liquid bath
- Layer-wise application and solidification of powder layers
- Layer-wise delivery of a binding agent into a powder composite
- Energy beam deposition method in metal powder
- Plastic extruder technology, e.g., Fused Deposition Modeling.

4. Casting mould according to any one of claims 1 to 3, **characterized in that** the at least two mould wall segments (G1-G5) and the hinge region are made integrally of a uniform material.

5. Casting mould according to any one of claims 1 to 3, **characterized in that** the hinge region is made of a different material than mould wall segments (G1-G5).

6. Casting mould according to any one of claims 1 to 5, **characterized in that** the mould wall segments (G1-G5) are conformed as panel elements which span a common plane, out of which at least three panel elements connected to at least one further panel element via the respective hinge regions are swivellable to form the casting mould during the manufacturing process.

7. Casting mould according to any one of claims 1 to 6, **characterized in that** at least two panel elements have joining edges, along which the at least two panel elements can be brought into a mutually flush position by swivelling them about the hinge region portion, and that the joining edges are shaped and/or provided with sealing means in such manner that the panel elements cooperate with each other to provide a sealing closure with respect to the flowable casting material during the casting process.

8. Casting mould according to claim 7, **characterized in that** the joining edges are formed in the manner of a mitred profile.

9. Casting mould according to any one of claims 1 to 8, **characterized in that** at least one casting mould wall has an inner wall surface facing the cast body (GK) that is to be produced, with at least one casting mould structure attached integrally thereto.

10. Casting mould according to claim 9, **characterized in that in that** the at least one casting mould structure is constructed as a holding or fixing structure for a body that is to be positioned inside the casting body.

11. Casting mould according to claim 10, **characterized in that** the body that is to be positioned is an actuator (A) of a sensor (S) that has a transducer material having.

12. Casting mould according to any one of claims 1 to 11, **characterized in that** a cavity in the manner of a channel, a tube or capillary is provided in at least one mould wall segment (G1-G5), and through which a cooling medium (KM) can be conducted.

13. Casting mould according to any one of claims 1 to 12, **characterized in that** at least one mould wall segment (G1-G5) includes at least a first wall area, which has a smaller wall thickness than the rest of the wall area of the casting mould segment (G1-G5), and that the first wall area is connected integrally to the rest of the wall area of the mould wall segment (G1-G5) via a predetermined breaking point, which breaks when the casting body (GK) is separated from the casting mould, and the first wall area remains attached to the casting body (GK).

## Revendications

1. Moule de coulée pour la fabrication d'un corps moulé (GK), comportant une paroi de moule de coulée entourant en suivant ses contours le corps moulé (GK) à fabriquer,
**caractérisé en ce que** la paroi de moule de coulée peut être divisée en au moins deux segments de paroi de moule de coulée (G1-G5) qui sont reliés ensemble par une partie articulée en formant une pièce et de manière étanche au fluide,
que la partie articulée est conçue et disposée de manière à ce que les au moins deux segments de paroi de moule de coulée (G1-G5) s'appuient avec faculté de pivotement mutuel autour d'un axe de pivotement associable à la partie articulée et
que les au moins deux segments de paroi de moule de coulée (G1-G5) et la partie articulée sont fabriqués au moyen d'un procédé de fabrication génératif.

2. Moule de coulée selon la revendication 1,
**caractérisé en ce que** la partie articulée est réalisée sous forme d'une articulation en film.

3. Moule de coulée selon la revendication 1 ou 2,
**caractérisé en ce que** le moule de coulée à fabriquer d'après la forme et la taille se présente sous forme d'un ensemble de données DAO qui peut être communiqué en tant que paramètres de fabrication à un procédé de fabrication génératif d'un des types suivants :
- prototypage rapide au moyen d'un procédé photolithographique
- photopolymérisation par durcissement par couches depuis un bain de liquide
- application par couches et solidification de couches poudreuses
- dépôt par couches d'un liant dans un composite poudreux
- procédé de dépôt au rayon énergétique dans de la poudre métallique
- technique d'extrusion de plastique, par exemple modélisation par dépôt de fil fondu.

4. Moule de coulée selon une des revendications 1 à 3,
**caractérisé en ce que** les au moins deux segments de paroi de moule de coulée (G1-G5) et la partie articulée sont fabriqués en une pièce à partir d'un matériau uniforme.

5. Moule de coulée selon une des revendications 1 à 3,
**caractérisé en ce que** la partie articulée est fabriquée à partir d'un matériau autre que celui des segments de paroi de moule de coulée (G1-G5).

6. Moule de coulée selon une des revendications 1 à 5,
**caractérisé en ce que** les segments de paroi de moule de coulée (G1-G5) se présentent sous forme d'éléments superficiels qui sous-tendent, dans le cadre du procédé de fabrication, un plan commun depuis lequel au moins trois éléments superficiels reliés par les parties articulées respectives à au moins un autre élément superficiel peuvent pivoter en formant le moule de coulée.

7. Moule de coulée selon une des revendications 1 à 6,
**caractérisé en ce que** les au moins deux éléments superficiels présentent des arêtes d'assemblage le long desquelles les au moins deux éléments superficiels peuvent être amenés en contact mutuel par pivotement autour de la partie articulée
et que les arêtes d'assemblage sont formées et/ou pourvues d'un produit d'étanchéité de manière à ce que les éléments superficiels se rejoignent hermétiquement au niveau du matériau de coulée fluide pendant le processus de coulée.

8. Moule de coulée selon la revendication 7,
**caractérisé en ce que**
les arêtes d'assemblage sont réalisées à la manière d'un profilé taillé en onglet.

9. Moule de coulée selon une des revendications 1 à 8,
**caractérisé en ce que** l'au moins une paroi de moule de coulée présente une surface de paroi interne tournée vers le corps moulé (GK) à fabriquer et dotée d'une structure de moule de coulée reliée à celui-ci en formant une seule pièce.

10. Moule de coulée selon la revendication 9,
**caractérisé en ce que** l'au moins une structure de moule de coulée est réalisée sous forme d'une structure de retenue ou de fixation pour un corps à positionner dans le corps moulé (GK).

11. Moule de coulée selon la revendication 10,
**caractérisé en ce que** le corps à positionner est un acteur (A) ou un capteur (S) présentant un matériau de conversion.

12. Moule de coulée selon une des revendications 1 à 11,
**caractérisé en ce qu'**il est prévu dans au moins un segment de paroi de moule de coulée (G1-G5) une cavité de type canal, tuyau ou capillaire dans laquelle un produit refroidisseur (KM) peut être conduit.

13. Moule de coulée selon une des revendications 1 à 12,
**caractérisé en ce qu'**au moins un segment de paroi de moule de coulée (G1-G5) présente une première partie de paroi qui présente une épaisseur de paroi inférieure à celle de l'autre partie de paroi du segment de paroi de moule de coulée (G1-G5) et que la première partie de paroi est reliée en formant une pièce avec l'autre partie de paroi du segment de paroi de moule de coulée (G1-G5) par une zone de rupture théorique qui casse lors de la séparation du corps moulé (GK) et du moule de coulée et que la première partie de paroi reste reliée au corps moulé (GK).
